# EUROPEAN PATENT APPLICATION

(11) **EP 2 637 169 A1**
(43) Date of publication of application: **11.09.2013**
(21) Application number: 12162706.1
(22) Date of filing: 30.03.2012
(51) Int. Cl.: G11B 19/02, H03K 17/74

(54) **Power enabling control circuit and electronic device using the same**

(30) Priority: 08.03.2012 CN 201210059394
(71) Applicant: Hong Fu Jin Precision Industry (ShenZhen) Co., Ltd., Shenzhen City, Guangdong 518109 (CN); Hon Hai Precision Industry Co., Ltd., New Taipei City (TW)
(72) Inventor: Cheng, Hai-Long, Shenzhen City, Guangdong Province (CN); Wang, Tao, Shenzhen City, Guangdong Province (CN); Deng, Xue-Bing, Shenzhen City, Guangdong Province (CN)
(74) Representative: Gray, John James

(57) **Abstract**

A power enabling control circuit is arranged in an electronic device. The electronic device includes a processor, a power integrated circuit, and a Moving Pictures Experts Group chip. The power enabling control circuit is connected to the processor and the Moving Pictures Experts Group chip for receiving a high level voltage from the processor or the Moving Pictures Experts Group chip. The power enabling control circuit is further connected to a power enabling port of the power integrated circuit to provide a high level voltage to the power enabling port based on the received high level voltage, causing the power integrated circuit in a working state to supply power to internal components of the electronic device.

## Description

### BackGround

### Technical Field

The present disclosure relates to a power enabling control circuit and an electronic device using the power enabling control circuit.

### Description of Related Art

It is known that most electronic devices, such as VCD players or DVD players, include power integrated circuits (POWER lC). The POWER lC has a power enabling port connected to a processor (a CPU or a MCU for example) of the electronic device. The processor is powered by an independent power source to make the processor work. When working, the processor provides a high level voltage to the power enabling port to enable the POWER lC to provide power to internal components of the electronic device. However, when the processor is restarted, for example, an application installed in the electronic device is updated to cause the processor to be restarted, the processor cannot provide a high level voltage to the power enabling port, thus causes the POWER lC to be shut down.

If the applications installed in the electronic device are updated frequently, it is necessary to make the power enabling port in a high level voltage all the time to save starting time of the POWER lC.

FIG.s 1 and 2 together show an electronic device 100 including a processor 10, a POWER lC 20, and a Moving Pictures Experts Group (MPEG) chip 30. The processor 10 is electrically connected to a power enabling port 201 of the power lC 20 to provide a high level voltage to the port 201 when the processor 10 is working. The MPEG chip 30 is connected to the processor 10, and further connected to the power enabling port 201 through a power enabling control circuit 40. The MPEG chip 30 provides a high level voltage to the power enabling control circuit 40 in response to a restarting signal from the processor 10 when the processor 10 is restarted. The power enabling control circuit 40 makes the power enabling port 201 in a high level voltage when the processor 10 is restarted, by the high level voltage provided by the MPEG chip 30. The electronic device 100 may be a VCD player, a DVD player, which is a multimedia player including a MPEG chip.

The power enabling control circuit 40 includes a first Bipolar Junction Transistor (BJT) Q1 and a second BJT Q2. The first BJT Q1 is a NPN BJT and the second BJT is a PNP BJT. A base of the first BJT Q1 is connected to ground through a first resistor R1 and a second resistor R2, a collector of the BJT Q1 is connected to a base of the second BJT Q2 through a third resistor R3, and further connected a high level voltage port V_{H} through a fourth resistor R4, and an emitter of the BJT Q1 is grounded. A collector of the second BJT Q2 is connected to the power enabling port 201 through a fifth resistor R5, and an emitter of the second BJT Q2 is connected to the high level voltage port V_{H}. The MPEG chip 30 is grounded through the second resistor R2.

When the processor 10 is working, the processor 10 provides a high level voltage to the power enabling port 201. When being restarted, the processor 10 sends the restarted signal to the MPEG chip 30, and the MPEG chip 30 outputs a high level voltage to the power enabling control circuit 40 in response to the restarted signal. Because the base of the first BJT Q1 is in a high level voltage, the first BJT Q1 is turned on, causing the base of the second BJT Q2 to ground through the third resistor R3 and the BJT Q1, thus, the second BJT Q2 is turned on. The power enabling port 201 is connected to the high level voltage port V_{H} through the BJT Q2 and the fifth resistor R5. Thus, the power enabling port 201 is in a high level voltage no matter if the processor 10 is working or restarted. However, the power enabling control circuit 40 includes a first BJT Q1 and a second BJT Q2 which make the structure of the power enabling control circuit 40 be complex and take much space of the electronic device 100.

### BRIEF DESCRIPTION OF THE DRAWINGS

The components in the drawing are not necessarily drawn to scale, the emphasis instead being placed upon clearly illustrating the principles of the present disclosure.

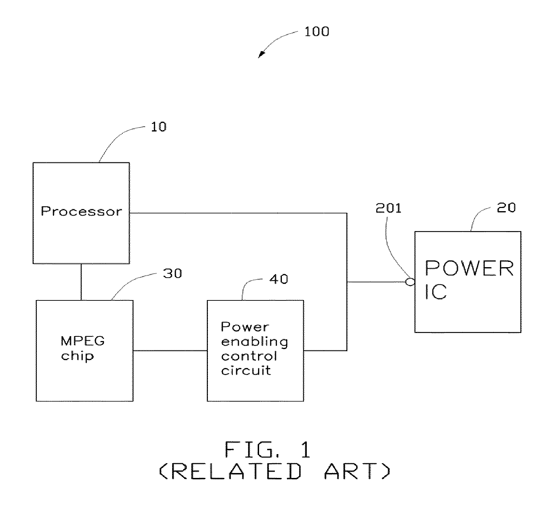

FIG. 1 is a module diagram of an electronic device using a power enabling control circuit in a related art.

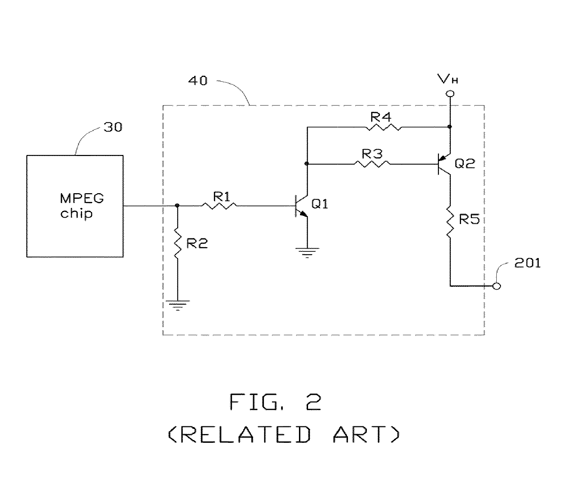

FIG. 2 is a circuit diagram of the power enabling control circuit of FIG. 1.

FIG. 3 is an improved power enabling control circuit in an electronic device, in accordance with an embodiment.

### DETAILED DESCRIPTION

The disclosure is illustrated by way of example and not by way of limitation. It should be noted that references to "an" or "one" embodiment in this disclosure are not necessarily to the same embodiment, and such references mean at least one.

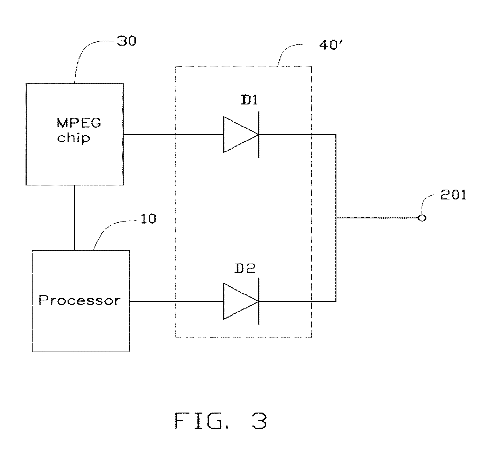

Referring to FIG. 3, comparing with the related art, the present disclosure provides an improved power enabling control circuit 40', while the processor 10, the POWER lC 20, and the MPEG chip 30 remain unchanged. The power enabling control circuit 40' is connected to the processor 10 and the MPEG chip 30 for receiving a high level voltage from the processor 10 or the MPEG chip 30. The power enabling control circuit 40' is further connected to the power enabling port 201 of the POWER lC 20, to provide a high level voltage to the power enabling port 201 based on the received high level voltage. The high level voltage on the power enabling port 20 enables the POWER lC 20 in a working state to supply power to internal components of the electronic device 100.

The power enabling control circuit 40' includes a first diode D1 and a second diode D2. An anode of the first diode D1 is connected to the MPEG chip 30. An anode of the second diode D2 is connected to the processor 10. A cathode of the first diode D1 and an cathode of the second diode D2 are both connected to the power enabling port 201.

When the processor 10 is working, the processor 10 outputs a high level voltage, the second diode D2 is turned on to make the power enabling port 201 in a high level voltage. When the processor 10 is restarted, the MPEG chip 30 outputs a high level voltage in response to the restarting signal from the processor 10, the first diode D1 is turned on to make the power enabling port 201 in a high level voltage. Therefore, no matter if the processor 10 is working or being restarted, the power enabling port 201 is in a high level voltage.

The power enabling control circuit 40' solves the same problem as the problem solved by the power enabling control circuit 40 in the prior art and reaches the same effect. However, the components of the power enabling control circuit 40' are less than that of the power enabling control circuit 40 and takes up less space in the electronic device 100.

Although the present disclosure has been specifically described on the basis of the exemplary embodiment thereof, the disclosure is not to be construed as being limited thereto. Various changes or modifications may be made to the embodiment without departing from the scope and spirit of the disclosure.

## Claims

1. A power enabling control circuit for being arranged in an electronic device, the electronic device comprising a processor, a power integrated circuit, and a Moving Pictures Experts Group chip, the power enabling control circuit comprising:
a first diode, an anode of the first diode being connected to the Moving Pictures Experts Group chip, and a cathode of the first diode of the first diode being connected to the power enabling port, and
a second diode, an anode of the second diode being connected to the processor, and a cathode of the second diode is connected to the power enabling port.

2. An electronic device comprising:
a processor;
a Moving Pictures Experts Group chip;
a power integrated circuit; and
a power enabling control circuit;
wherein the processor and the Moving Pictures Experts Group chip are connected to the power enabling control circuit, the power enabling control circuit is connected to a power enabling port of the power integrated circuit, the processor provides a high level voltage to the power enabling control circuit when the processor is in a working state, the Moving Pictures Experts Group chip is connected to the processor, for providing a high level voltage to the power enabling control circuit in response to a restart signal from the processor, and the power enabling control circuit outputs a high level voltage to the power enabling port of the power integrated circuit based on the received high level voltage from the processor or the Moving Pictures Experts Group chip, causing the power integrated circuit working to supply power to internal components of the electronic device.

3. The electronic device as described in claim 2, wherein the power enabling control circuit comprises a first diode and a second diode, the Moving Pictures Experts Group chip is connected to an anode of the first diode, the processor is connected to an anode of the second diode, and a cathode of the first diode and an cathode of the second diode are connected together to the power enabling port.
